# EUROPEAN PATENT APPLICATION

(11) **EP 2 664 928 A1**
(43) Date of publication of application: **20.11.2013**
(21) Application number: 12734151.9
(22) Date of filing: 12.01.2012
(51) Int. Cl.: G01R 1/067

(54) **METHOD FOR MANUFACTURING INSPECTION PROBE**

(30) Priority: 13.01.2011 JP 2011004928
(71) Applicant: Sankei Engineering Co., Ltd., Yokohama-shi, Kanagawa 222-0033 (JP); Rokkaku, Tadashi, Fuchu-shi, Tokyo 183-0034 (JP)
(72) Inventor: ROKKAKU, Tadashi, Fuchu-shi Tokyo 183-0034 (JP); KASAHARA, Hisayoshi, Yokohama-shi Kanagawa 222-0033 (JP)
(74) Representative: Klunker . Schmitt-Nilson . Hirsch
(86) International application number: PCT/JP2012/050442
(87) International publication number: WO 2012/096333

(57) **Abstract**

This is to provide a method for manufacturing an inspection probe in which qualities of a bonded portion of the inspection probe constituted by bonding wire rods comprising different metals are improved.

The method for manufacturing an inspection probe is configured by bonding a first wire rod 110 and a second wire rod 120, at least one of which has an inspection contact portion at a tip thereof, performing laser welding by irradiating laser beam to outer circumferential surfaces of the first wire rod and the second wire rod with different energy quantities, and then, polishing the outer circumferential surfaces.

## Description

### TECHNICAL FIELD

The present invention relates to a method for manufacturing an inspection probe to be used for a probe card, etc., which is to carry out an electrical continuity inspection of a semiconductor, particularly those in which qualities at the bonded portion of an inspection probe configured by welding wire rods with different metals having different melting points are improved.

### BACKGROUND ART

As an inspection probe (probe pin) to be used for an inspection probe such as a probe card, a wire probe, a zebra probe, a cobra probe, etc., it has been known to use iridium excellent in corrosion resistance and wear resistance, a platinum alloy excellent in corrosion resistance and a palladium alloy excellent in electric characteristics.
However, noble metal materials such as iridium, a platinum alloy and a palladium alloy are expensive, so that when a whole body of the inspection probe is produced by using these materials, the resulting probe becomes extremely expensive.
Further, iridium is a hard and brittle material, so that when it is tried to be used for the whole probe, its processing is difficult. Moreover, when a platinum alloy or a palladium alloy is tried to be used for the whole probe, it is difficult to obtain elasticity or toughness required for the probe.
Thus, it has been tried to constitute an inspection probe by using a noble metal such as iridium, a platinum alloy and a palladium alloy at a tip of the inspection probe, and using tungsten, a rhenium tungsten alloy or beryllium copper excellent in elasticity, toughness and electrical conductivity at the portion other than the tip (body portion) by bonding these.

As a prior art with regard to an inspection probe in which different metals are bonded, for example, in Patent Document 1, there is disclosed that resistance welding is carried out by passing large current to a bonding surface of a probe body comprising tungsten and a tip comprising a palladium alloy.
In Patent Document 2, there is disclosed that to a probe body comprising tungsten, etc., is bonded a tip comprising different material by ultrasonic vibration bonding, and then, the tip including the bonded portion is subjected to a tip processing.
In Patent Document 3, there is disclosed a probe pin comprising different materials in which to a tip of a probe comprising tungsten or rhenium tungsten is bonded titanium, nickel or an alloy thereof by brazing.
In Patent Document 4, there is disclosed a different metal-bonded probe in which a copper wire is bonded to a rear end portion of the probe portion comprising tungsten by resistance welding or laser welding.

### PRIOR ART DOCUMENT

### PATENT DOCUMENT

[Patent Document 1] JP 2000-137042A
[Patent Document 2] JP 2007-271472A
[Patent Document 3] JP 2007-147483A
[Patent Document 4] JP 2000-187043A

### SUMMARY OF THE INVENTION

### PROBLEMS TO BE SOLVED BY THE INVENTION

However, such an inspection probe is fine, so that it is difficult to heighten qualities at the bonded portion such as precision, strength, reliability, etc.
For example, in a vertical type probe card to be used for an inspection of a semiconductor in recent years, an inspection probe having a diameter of 35 microns to 50 microns has been used.
When such fine wire rods comprising different metals are to be bonded, it is difficult by brazing as disclosed in Patent Document 1 to sufficiently ensure the area of an interface between a wire rod and a brazing material, whereby there causes a fear in bonding strength.
In addition, in resistance welding which requires to pass large current as in Patent Document 2, or in ultrasonic vibration bonding which requires to act potent axial force between wire rods to bond the edge surfaces by pressure as in Patent Document 3, when a diameter of the wire rod is fine, it is difficult to obtain good qualities of the bonding portion.
When laser welding is performed as in Patent Document 4, it is not necessary to act large current or compression bonding force to the wire rod, and controllability in heating calorie is excellent so that relatively good qualities at the bonded portion can be obtained even when it is a fine probe.
However, in the case of a probe in which different metals are bonded, melting points of the wire rods to be bonded are different from each other in many cases, so that there are fears in lowering welding quality due to excess melt of a lower melting point material or melt failure of a higher melting point material.
In the case of an inspection probe in which wire rods comprising different metals are welded, there is a case where quality of a bonded portion is impaired by generating a shrinkage cavity at the surface of the welded portion.
In view of the above-mentioned problems, an object of the present invention is to provide a method for manufacturing an inspection probe in which quality of a bonded portion of an inspection probe constituted by bonding wire rods comprising different metals is improved.

### MEANS TO SOLVE THE PROBLEMS

The present invention is to solve the above-mentioned problems by the following solving means.
The invention of Claim 1 is a method for manufacturing an inspection probe, which is configured by bonding a first wire rod and a second wire rod, at least one of which has an inspection contact portion at a tip thereof, which comprises laser welding the first wire rod and the second wire rod in a state of putting together by irradiating laser beam to outer circumferential surfaces at a bonded portion, and an energy quantity applied to a material of a higher melting point side among the first wire rod and the second wire rod by the laser beam is made larger than an energy quantity applied to a material of a lower melting point side.
According to this method, the first wire rod and the second wire rod can be melted instantaneously by irradiation of laser beam to carry out welding without acting a large axial force or passing large current to the first wire rod and the second wire rod as in ultrasonic vibration bonding or resistance welding, making the quality of the bonding portion good even when it is a fine probe in which different metals are bonded, and can ensure precision, strength, reliability, etc.
In addition, by making an energy quantity applied to a side having a higher melting point of the material among the first wire rod and the second wire rod larger than an energy quantity applied to a side having a lower melting point, even when wire rods comprising materials having different melting points are bonded, fusion failure of the higher melting point material or excess melt of the lower melting point material can be prevented, and a timing of melting the both materials can be matched to obtain good welding quality. The energy quantity herein mentioned is to be meant that a heat quantity provided directly or indirectly (for example, heat conduction from the other wire rod, etc.) to each wire rod by irradiation of laser beam is integrated by the time from initiation of the heating to completion of the same.
Thus, to differentiate the energy quantity provided to each wire rod can be realized by, for example, irradiating laser beam only to the wire rod of a higher melting point material, and the wire rod of a lower melting point material is heated by heat conduction from the wire rod of a higher melting point material.
The wire rod of a higher melting point material is pre-heated by irradiating laser beam, and then, the laser beam is irradiated to the bonding portion of the wire rods of the higher melting point material and the lower melting point material to weld these materials.
One or both of an energy quantity and an irradiation time of the laser beam irradiated to the wire rod of a higher melting point material and the laser beam irradiated to the wire rod of a lower melting point material may be differentiated. The energy quantity of the laser beam can be controlled by, for example, setting parameters such as a voltage, frequency, heat quantity (joule), etc., of a laser welding machine, and the energy quantity per a unit area can be also changed by changing a laser diameter.
Also, by making a diameter of the lower melting point material larger than a diameter of the higher melting point material, so that the volume at the portion to be melted is changed, whereby energy quantities and irradiation times of the laser beam to be irradiated may be the same.
The energy quantity of the laser beam can be measured by irradiating a laser beam to a sensor portion of an existing laser power meter.

The invention of Claim 2 is the method for manufacturing an inspection probe described in Claim 1, wherein after the laser welding is performed, outer circumferential surfaces at a welded portion are polished to an outer diameter of a product.
The invention of Claim 3 is a method for manufacturing an inspection probe which is configured by bonding a first wire rod and a second wire rod, at least one of which has an inspection contact portion at a tip thereof, which comprises laser welding the first wire rod and the second wire rod in a state of putting these together by irradiating laser beam to outer circumferential surfaces at a bonded portion, and after the laser welding is performed, outer circumferential surfaces at a welded portion are polished to an outer diameter of a product.
According to this method, dimensional accuracy or surface smoothness of the product can be made good even when an outer diameter of at least one of the wire rods is larger than a final outer diameter of the product, or a step, a shrinkage cavity, etc., is generated at the welded portion.
In such a polishing, there may be used, for example, the conventionally known centerless polishing, etc.
In the present specification and the claims, the outer diameter of the product is to be meant an outer diameter at the said portion when an inspection probe is utilized for inspection as a final product (a finished product).

The invention of Claim 4 is the method for manufacturing an inspection probe described in any one of Claim 1 to Claim 3, wherein a convex portion is formed at one of edge surfaces of the first wire rod and the second wire rod, and a concave portion which is engaged with the convex portion and to guide the first wire rod and the second wire rod to be substantially concentric is formed at the edge surface of the other.
According to this method, when the first wire rod and the second wire rod are putting together, these can be easily provided (centering) concentric, and a product with good precision can be obtained simply and easily.

The invention of Claim 5 is a method for manufacturing an inspection probe which is configured by bonding a first wire rod and a second wire rod which are formed by materials having different melting points, at least one of which has an inspection contact portion at a tip thereof, which comprises forming a metal coating comprising a material having a higher melting point than a melting point of a material of the wire rods at a bonding surface of a side having a lower melting point among materials of the first wire rod and the second wire rod, putting the first wire rod and the second wire rod together, and are welded by heating.
According to this method, even when it is difficult to directly weld the first wire rod and the second wire rod since their melting points are different from each other, a metal coating comprising a material having a higher melting point than a melting point of a material of the wire rod is formed at a bonding surface of the wire rod having a lower melting point of the material, whereby making the difference of the melting points at the welded portion, welding can be well carried out.
The invention of Claim 6 is the method for manufacturing an inspection probe described in Claim 5, wherein a convex portion is formed at one of a bonding surface of the first wire rod and a bonding surface of the second wire rod, and a concave portion which is engaged with the convex portion is formed at a bonding surface of the other, and the first wire rod and the second wire rod are putting together so that the convex portion and the concave portion are engaged with, and are welded by heating.
According to this method, by forming a convex portion and a concave portion at the bonding surfaces of the first wire rod and the second wire rod, a surface at the interface of the wire rod and the metal coating can be enlarged, and simultaneously, a welding surface of the metal coating and the other wire rod can be enlarged, so that the bonding strength of the first wire rod and the second wire rod can be improved.
Moreover, the convex portion and the concave portion act as guides for arranging the first wire rod and the second wire rod to be concentric, whereby precision at the bonding portion can be ensured.

The invention of Claim 7 is the method for manufacturing an inspection probe described in Claim 5 or Claim 6, wherein the metal coating is formed by sputtering, plating or vapor deposition using a material having a melting point closer to a higher melting point among the material of the first wire rod and the material of the second wire rod than a lower one.
According to this method, difference between the melting points at the welded portion is made smaller, whereby welding quality can be further improved.

The invention of Claim 8 is a method for manufacturing an inspection probe which is configured by bonding a first wire rod and a second wire rod which are formed by materials having different melting points, at least one of which has an inspection contact portion at a tip thereof, which comprises forming a metal coating comprising a material having a lower melting point than a melting point of a material of the wire rods at a bonding surface of a side having a higher melting point among materials of the first wire rod and the second wire rod, putting the first wire rod and the second wire rod together, and welding these by heating.
According to this method, even when it is difficult to directly weld the first wire rod and the second wire rod due to different melting points, a metal coating comprising a material having a melting point lower than a melting point of the material of the wire rod is formed on the bonding surface of the wire rod at the side having a higher melting point of the material, whereby making the difference between the melting points at the welding portion small, welding can be well carried out.
The invention of Claim 9 is the method for manufacturing an inspection probe described in Claim 8, wherein a convex portion is formed at one of a bonding surface of the first wire rod and a bonding surface of the second wire rod, and a concave portion which is engaged with the convex portion is formed at the other, and the first wire rod and the second wire rod are putting together so that the convex portion and the concave portion are engaged with, and are welded by heating.
According to this method, by forming the convex portion and the concave portion at the bonding surface of the first wire rod and the second wire rod, an area of an interface between the wire rod and the metal coating can be enlarged, and simultaneously, the welding area of the metal coating and the other wire rod can be also enlarged whereby the bonding strength of the first wire rod and the second wire rod can be improved.
Moreover, the convex portion and the concave portion act as guides for arranging the first wire rod and the second wire rod to be concentric, precision at the bonding portion can be ensured.

The invention of Claim 10 is the method for manufacturing an inspection probe described in Claim 8 or Claim 9, wherein the metal coating is formed by sputtering, plating or vapor deposition using a material having a melting point closer to a lower melting point among the material of the first wire rod and the material of the second wire rod than a higher one.
According to this method, by making the difference in melting points at the welding portion smaller, welding quality can be further improved.

The invention of Claim 11 is the method for manufacturing an inspection probe described in any one of Claim 1 to Claim 10, wherein at least one of the first wire rod and the second wire rod is formed by either one of tungsten, a tungsten alloy, a copper alloy, a silver alloy, a palladium alloy or a gold alloy, and the other is formed by iridium or an iridium alloy.
According to this method, even when iridium or an iridium alloy is used at a tip of the inspection probe, which is excellent in corrosion resistance and wear resistance but hard and brittle, performance of the inspection probe as a whole can be heightened by using, as a body portion, tungsten, a tungsten alloy, a copper alloy, a silver alloy, a palladium alloy or a gold alloy which are excellent in elasticity, toughness and electrical conductivity.

The invention of Claim 12 is the method for manufacturing an inspection probe described in any one of Claim 1 to Claim 11, wherein at least one of the first wire rod and the second wire rod has an outer diameter larger than an outer diameter of a product, and outer circumferential surfaces including the bonded portion is polished to the outer diameter of a product after welding the first wire rod and the second wire rod.
According to this method, even when a shrinkage cavity is generated at the welding, an inspection probe with a uniform outer diameter of a product can be obtained without performing padding.
In the present specification and the claims, an outer diameter of a product is to be meant an outer diameter at the neighbor of the welded portion at the time of using the inspection probe as a final product.

The invention of Claim 13 is the method for manufacturing an inspection probe described in any one of Claim 1 to Claim 11, wherein the first wire rod and the second wire rod are welded, and then, a ring member made of a metal is provided at a periphery of the bonded portion and melted to fill a wall reduced portion caused by welding.
According to this method, a shrinkage cavity generated at the time of welding can be easily filled to obtain an inspection probe with a uniform outer diameter of a product.
In this case, the outer circumferential surfaces at the bonded portion may be polished after melting the ring member.

The invention of Claim 14 is the method for manufacturing an inspection probe described in any one of Claim 1 to Claim 11, wherein an outer diameter of the first wire rod is formed larger than that of the second wire rod and the first wire rod has a hole portion at an edge surface into which the second wire rod is to be inserted, and after performing laser welding of the first wire rod and the second wire rod in a state that the second wire rod is inserted into the hole portion of the first wire rod, outer circumferential surfaces of the first wire rod are polished to an outer diameter of a product.
According to this method, by setting the difference between the outer diameter of the first wire rod and the final outer diameter of the product larger than a shrinkage cavity amount at the time of welding, a product having a desired outer diameter of the product can be obtained without performing padding, etc., at the shrinkage cavity portion.

The invention of Claim 15 is a method for manufacturing an inspection probe which is configured by bonding a first wire rod and a second wire rod, at least one of which has an inspection contact portion at a tip thereof, which comprises, in a state that an edge surface of the first wire rod and an edge surface of the second wire rod are putting together, arranging the portion at which the rods are putting together at an inner diameter side of a cylindrical member, irradiating laser beam to the cylindrical member to perform laser welding the cylindrical member to the first wire rod and the second wire rod, respectively, and polishing outer circumferential surfaces of the welded portion to an outer diameter of a product.
According to this method, a shrinkage cavity generating at the welded portion of the first wire rod and the second wire rod is filled up by a melted cylindrical member, so that even when a wire rod having the same or slightly larger outer diameter as the final outer diameter of the product is used as the first wire rod and the second wire rod, a product having a desired outer diameter of the product can be obtained without subjecting to any post-treatment such as padding, etc., to a shrinkage cavity.

The invention of Claim 16 is the method for manufacturing an inspection probe described in Claim 15, wherein the first wire rod and the second wire rod are constituted by materials having different melting points, and a material of the cylindrical member has a melting point closer to a higher melting point than a lower one among the material of the first wire rod and the material of the second wire rod.
According to this method, when the cylindrical member is melted, that having a lower melting point is melted instantaneously among the materials of the first wire rod and the second wire rod, so that good quality of the welded portion can be ensured.

The invention of Claim 17 is the method for manufacturing an inspection probe described in any one of Claim 1 to Claim 16m wherein after the laser welding is performed, a metal coating is formed at outer circumferential surfaces of a welded portion, and then, polishing thereof is carried out.
According to this method, a shrinkage cavity generated by the welding can be filled up by a metal coating, a product having a desired outer diameter of the product can be obtained.
The invention of Claim 18 is the method for manufacturing an inspection probe described in any one of Claim 1 to Claim 17, wherein after polishing outer circumferential surfaces at a welded portion, a metal coating is formed thereto.
According to this method, strength at the bonded portion can be improved by the metal coating.
The invention of Claim 19 is the method for manufacturing an inspection probe described in Claim 17 or Claim 18, wherein the metal coating is a nickel coating.
The invention of Claim 20 is the method for manufacturing an inspection probe described in Claim 19, wherein a coating comprising at least one of gold, rhodium and platinum is formed on the surface of the nickel coating.
In this case, when a gold coating is formed, electric characteristics at normal temperature can be improved.
Also, when a platinum coating is formed, corrosion resistance at high temperatures can be improved.
In addition, when a rhodium coating is formed, corrosion resistance at high temperatures and wear resistance can be improved.
Such a coating comprising nickel, gold, rhodium, platinum, etc., can be typically formed by plating, and it is also possible to use other thin-film forming techniques, for example, vapor deposition, sputtering, etc.

### EFFECTS OF THE INVENTION

As explained above, according to the present invention, it can be provided a method for manufacturing an inspection probe improved in qualities of the bonded portion of the inspection probe constituted by bonding wire rods comprising different metals.

### BRIEF DESCRIPTION OF THE DRAWINGS

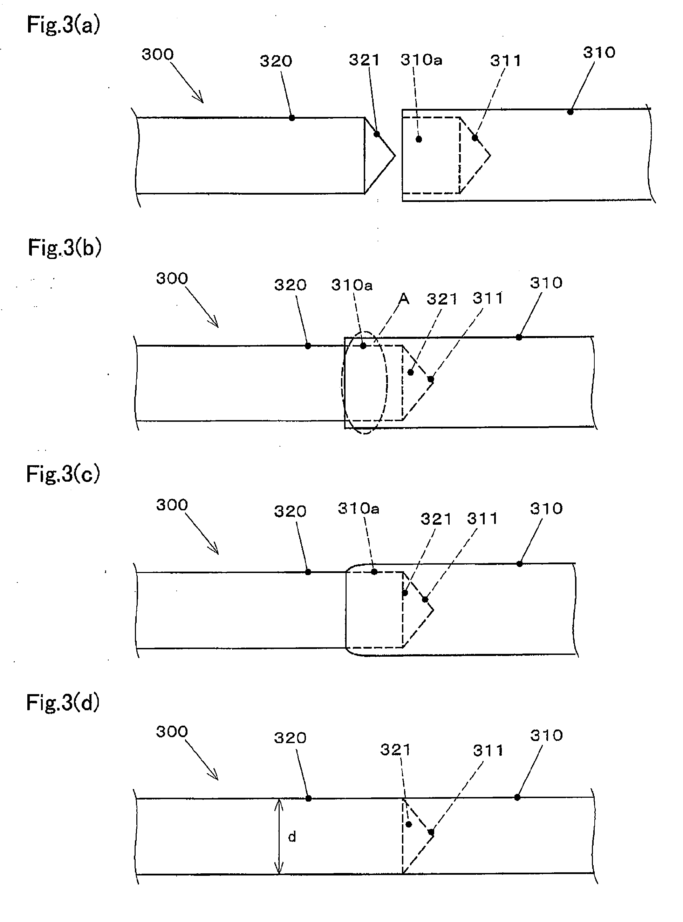

Fig. 1 is a drawing showing the first embodiment of a method for manufacturing an inspection probe to which the present invention is applied, Fig. 1(a) shows the state before putting wire rods together, Fig. 1(b) shows the state at the time of performing laser welding by putting the wire rods together, Fig. 1(c) shows the state after the laser welding, and Fig. 1(d) shows the state at which the polishing has been completed (which are the same in Fig. 2 to Fig. 4).
Fig. 2 is a drawing showing the second embodiment of a method for manufacturing an inspection probe to which the present invention is applied.
Fig. 3 is a drawing showing the third embodiment of a method for manufacturing an inspection probe to which the present invention is applied.
Fig. 4 is a drawing showing the fourth embodiment of a method for manufacturing an inspection probe to which the present invention is applied.
Fig. 5 is a drawing showing the sixth embodiment of a method for manufacturing an inspection probe to which the present invention is applied, Fig. 5 (a) shows the state before putting wire rods together, Fig. 5(b) shows the state that the wire rods are putting together, Fig. 5(c) shows the state at which the welding has been completed, and Fig. 5(d) shows the state at which the polishing has been completed. Incidentally, the metal coating is shown in the drawing with thick than the actual to facilitate the understanding.
Fig. 6 is a drawing showing the seventh embodiment of a method for manufacturing an inspection probe to which the present invention is applied, Fig. 6(a) shows the state that the welded portion is inserted into a cylindrical member, Fig. 6 (b) shows the state that the cylindrical member is melted, and Fig. 6(c) shows the state the polishing has been completed.

### EMBODIMENT TO CARRY OUT THE INVENTION

In the following, the first to the seventh embodiments of the methods for manufacturing an inspection probe to which the present invention is applied are explained by referring to the drawings, etc.

### <First embodiment>

An inspection probe 100 of the first embodiment comprises, for example, a first wire rod 110 comprising iridium as a tip at which an inspection contact portion is to be formed, and a second wire rod 120 comprising, for example, a rhenium tungsten alloy being bonded at the edge portion as a body portion.
This inspection probe can be utilized as, for example, a probe pin of a probe card, or various probe pins such as a wire probe, zebra probe, etc.
The inspection probe 100 can be made a tip of, for example, 6 to 10 mm, when it is a probe for a cantilever system probe card having the total length of, for example, 60 to 150 mm. In this case, it can be configured that the bonding portion of the first wire rod 110 and the second wire rod 120 is buried in the inside of a resin for fixing the probe of a cantilever system probe card.

Such a combination of the materials, use, shape and dimensions are one of examples, and they can be optionally changed.
For example, in the case of a vertical probe in which the center portion is curved to S character shape, or bent to L character shape to have an elastic recovery power, it can be configured that an iridium wire rod having, for example, 0.5 to 2 mm or so is bonded as a tip to the bottom portion or the upper and bottom portions of a body portion comprising a copper alloy wire rod, and a rust preventing plating such as gold, nickel, etc., is applied on outer circumferential surfaces of the copper alloy wire rod.

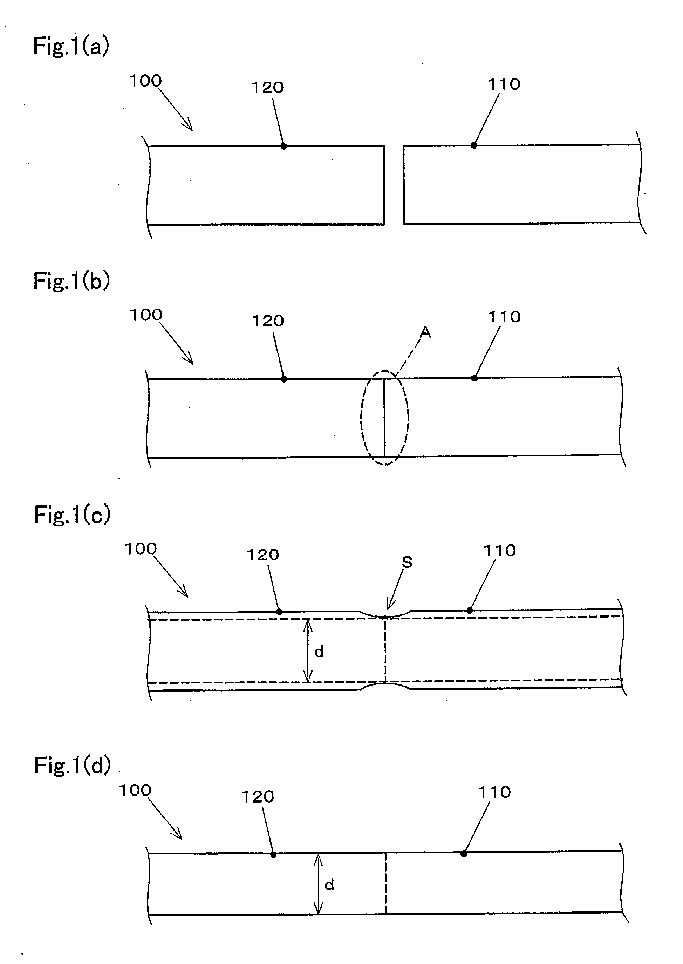

The rhenium tungsten alloy is an alloy comprising, for example, 0.1 to 30% by weight of rhenium and the remainder being substantially tungsten, and it is possible to control the melting point based on the content of the rhenium.
The melting point of iridium is 2454°C, and the melting point of tungsten simple substance is as high as 3380°C. When these metals are to be welded, their welding qualities become a problem, but by increasing the content of the rhenium, the melting point thereof is closed to that of iridium, whereby the welding quality can be easily ensured.
As the first wire rod 110 and the second wire rod 120, those having a larger diameter than that of a final outer diameter d of the product are prepared, and the edge surfaces (bonding surfaces) at which the both rods are to be bonded are so finished that these surfaces are in flat surfaces at which central axes of each wire rod cross right angles. The outer diameter d of the product is, for example, 1 mm or less, and the present invention is extremely useful for those of fine material, particularly 0.1 mm or less.
These are so provided as to be coaxial as shown in Fig. 1(a).

Next, as shown in Fig. 1(b), the first wire rod 110 and the second wire rod 120 are fixed to a tool in the state that the edge surfaces of which are contacted to each other, and laser beam is irradiated to the outer circumferential surfaces at the region A showing with a broken line at the neighbor of the bonding portion under an inert gas atmosphere such as argon, etc., to melt the first wire rod 110 and the second wire rod 120 to perform laser welding.
At this time, the laser beam is, for example, subjected to spot irradiation with a pulse state while rotating the first wire rod 110 and the second wire rod 120 at around the central axis sequentially, whereby the welding portions are melted instantaneously.
Suitable strength of the laser beam depends on a material or a rod diameter, so that these are optionally set.

When the laser beam is irradiated, it is so configured that the energy quantity applied to a material of a higher melting point side among the materials of the first wire rod 110 and the second wire rod 120 by the laser beam is made larger than the energy quantity applied to the material of a lower melting point side. That is, in this embodiment, the laser beam is so irradiated that the energy quantity becomes larger to the second wire rod 120 made of a rhenium tungsten alloy having a relatively higher melting point than that of the first wire rod 110 made of iridium having a relatively lower melting point.
Control of the energy quantity can be realized by, for example, irradiating the laser beam only to the second wire rod 120 which is a higher melting point material, and the first wire rod 110 which is a lower melting point material is heated by heat conduction from the second wire rod 120 side.
It may be also carried out by heating the second wire rod 120 alone by subjecting to pre-irradiation of the laser beam beforehand, and then, irradiating the laser beam to the first wire rod 110 and the second wire rod 120.
Further, the energy quantity of the laser beam irradiated to the second wire rod 120 may be made larger than the energy quantity of the laser beam irradiated to the second wire rod 110, or the irradiated pulse width (time) to the second wire rod 120 may be made larger than the irradiated pulse width (time) to the first wire rod 110.
Moreover, by making the rod diameter of the first wire rod 110 having a lower melting point thicker than the rod diameter of the second wire rod 120 having a higher melting point to change the volume of the portion to be melted, the energy quantity and the irradiation time of the laser beam to be irradiated may be set to the same.
If the melting points of the materials of the first wire rod 110 and the second wire rod 120 are close to each other, and melt failure is not generated even if equal energy is applied to each wire rod, the energy quantity and the irradiation time of the laser beam to be irradiated can be made the same.

When the laser welding is performed, it causes a welding shrinkage cavity where the outer circumferential surface portion of the welded portion sunk inner diameter side as compared to the other portion as shown in Fig. 1(c).
For setting outer diameters of base materials of each wire rod and setting the welding conditions, a minimum diameter at the welding shrinkage cavity portion S is set to be larger than the an outer diameter of the product.

Next, the outer circumferential surfaces of the first wire rod 110 and the second wire rod 120 including the welded portion are polished (ground) by, for example, the conventionally known centerless polishing, etc., to finish the outer diameter to the final outer diameter d of the product.
Thereafter, a necessary processing such as a tip processing is applied to the tip (a contact portion contacted to the object to be measured and provided at the opposite side to the welded portion) of the first wire rod 110 not shown in the drawing, and further, if necessary, bending is applied to the second wire rod 120 to complete the inspection probe.

When a metal coating is formed by, for example, nickel plating, etc., to the outer circumferential surfaces including the welded portion of the inspection probe after polishing, strength at the bonded portion can be improved thereby.
Also, by using the metal coating such as nickel plating, etc., as an undercoating, a metal coating such as gold, rhodium and platinum can be formed thereon by plating.
When a gold plating is applied, electric characteristics at normal temperature can be improved.
When a platinum plating is applied, corrosion resistance at high temperatures can be improved.
When a rhodium plating is applied, corrosion resistance and wearing property at high temperatures can be improved.
After applying the plating to the whole inspection probe, the tip comprising iridium, etc. , is polished to a needle shape, the plated coating is removed from the tip at this time, so that no effect is exerted to the performance of the tip.

According to the first embodiment as explained above, the following effects can be obtained.
(1) Welding can be performed by melting the first wire rod 110 and the second wire rod 120 instantaneously by irradiation of the laser beam, without acting larger axial forces to or applying a large current to the first wire rod 110 and the second wire rod 120 as in the ultrasonic vibration bonding or the resistance welding, and qualities of the bonded portion can be made good even when it is a fine probe bonded different metals, whereby precision, strength and reliability can be ensured.
(2) By making the energy quantity applied to the second wire rod 120 having a higher melting point of the material among the first wire rod 110 and the second wire rod 120 larger than the energy quantity applied to the first wire rod 110, even when wire rods comprising materials having different melting points are to be bonded, fusion failure of the higher melting point material or excess melt of the lower melting point material can be prevented, and a timing of melting the both materials can be matched to obtain good welding quality.
(3) By setting the difference between the outer diameters of the first wire rod 110 and the second wire rod 120 and the final outer diameter d of the product larger than the shrinkage cavity amount at the welding, a product having a desired outer diameter of a product can be obtained by polishing alone without performing padding, etc., at the shrinkage cavity portion S.
(4) Even when iridium is used as the tip of the inspection probe 100, which is excellent in corrosion resistance and wear resistance but hard and brittle, by using a rhenium tungsten alloy excellent in elasticity, toughness and electrical conductivity for the body portion, performance of the inspection probe as a whole can be heightened.
(5) By irradiating the laser beam while rotating the first wire rod 110 and the second wire rod 120, stress-strain at the bonded portion can be equalized so that reliability can be heightened.
(6) By applying a nickel plating to the outer circumferential surfaces including the welded portion, strength at the bonded portion can be improved.
(7) By plating either one of gold, rhodium and platinum using the nickel plating as an undercoat, electric characteristics, corrosion resistance and wear resistance can be improved.

### <Second embodiment>

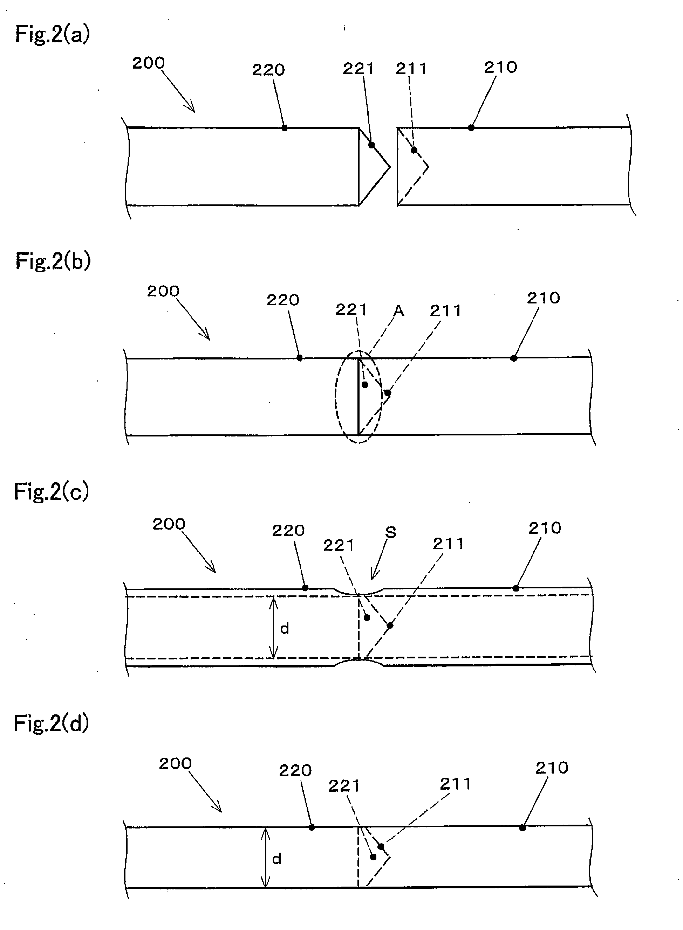

Next, the second embodiment of the method for manufacturing an inspection probe to which the present invention is applied is explained.
In the respective embodiments explained below, the substantially common parts with the previous embodiment are applied the same reference numerals of the last two digits, and duplicate explanation is omitted.
In the second embodiment, the inspection probe 200 employs as the second wire rod 220 constituting the body portion, a copper alloy wire rod such as a beryllium copper alloy in which a rust preventing plating such as gold and nickel is applied to the outer circumferential surfaces. As the first wire rod 210 constituting the tip, iridium which is the same as in the first embodiment, etc., is used. The material of the second wire rod 220 has a lower melting point than that of the material of the first wire rod 210.
The inspection probe 200 of the second embodiment shown in Fig. 2 is configured that a convex portion 221 tip processed to a taper shape is formed at the edge surface of the second wire rod 220, and a concave portion 211 with a taper shape which engages with the convex portion 221 is formed at the edge surface of the first wire rod 210.
These convex portion 221 and concave portion 211 play the roles to guide the centering of the both to be concentric, when the first wire rod 210 and the second wire rod 220 are putting together, and to be fixed to a tool, prior to laser welding.
The concave portion 211 of the first wire rod 210 side can be formed, for example, by laser processing, electric discharge machining, etc.
The convex portion 221 of the second wire rod 220 side can be formed, for example, by polishing.
According to the second embodiment as explained above, in addition to the same effects as in the effects of the above-mentioned first embodiment, centering of each wire rod becomes easy, so that the inspection probe having high precision can be easily obtained.
Also, the convex portion 221 of the second wire rod 220 inserted into the concave portion 211 of the first wire rod 210 is heated by heat conduction from the first wire rod 210 side, welding defect due to excess melt of the second wire rod 220 having a lower melting point or melt failure of the first wire rod 210 having a higher melting point can be prevented. Moreover, by adjusting a taper angle, etc., it is possible to control the melting states of the respective parts.

### <Third embodiment>

Next, the third embodiment of the method for manufacturing an inspection probe to which the present invention is applied is explained.
In the third embodiment, the inspection probe 300 employs, as the second wire rod 320 constituting the body portion, a copper alloy wire rod such as a beryllium copper alloy, etc., in which a rust preventing plating such as gold and nickel is applied to the outer circumferential surfaces. As the first wire rod 310 constituting the tip, iridium which is the same as in the first embodiment, etc., is used.
Also, in the third embodiment, a second wire rod 320 used is that the outer diameter of which is the same as the final outer diameter d of the product, and only a first wire rod 310 used is that the outer diameter of which is larger than the outer diameter d of the product. At the edge portion of the first wire rod 310, a hole portion 310a into which the edge portion of the second wire rod 320 is to be inserted is formed. An inner diameter of the hole portion 310a is made larger with the minimum gap inevitably provided to the outer diameter of the second wire rod 320.
At the edge portion of the second wire rod 320, a convex portion 321 which is substantially the same as in the convex portion 221 of the second embodiment is formed.
At the edge portion (bottom portion) of the hole portion 310a of the first wire rod 310, a concave portion 311 which is engaged with the convex portion 321 is formed.
In the third embodiment, the second wire rod 320 is inserted into the hole portion 310a of the first wire rod 310 until the convex portion 321 and the concave portion 311 are contacted to fix to a tool, and after laser welding, the outer circumferential surfaces of the first wire rod 310 is subjected to centerless polishing to the outer diameter d of the product (outer diameter of the first wire rod 310).

At the laser welding, since the melting point of iridium constituting the first wire rod 310 is higher than the melting point of the beryllium copper alloy constituting the second wire rod, the laser beam is irradiated to the first wire rod 310 alone, and the second wire rod 320 is heated and melted by heat conduction from the first wire rod 310, whereby good welding quality can be obtained.
In the third embodiment as explained above, in addition to substantially the same effects as in the above-mentioned first embodiment and the second embodiment, by setting the difference between the outer diameter of the first wire rod 310 and the final outer diameter d of the product larger than a shrinkage cavity amount at the time of welding, a product having a desired outer diameter d of the product can be obtained only by polishing without performing padding, etc. , at the shrinkage cavity portion.
Also, it is not necessary to polish the outer circumferential surfaces of the second wire rod constituting a relatively long body portion to the tip as in the first and the second embodiments, a number of the steps of the polishing can be reduced.
Moreover, by changing the outer diameter of the first wire rod 310 or an inserting depth of the second wire rod 320, an amount of heat transferred from the first wire rod 310 to the second wire rod 320 can be controlled, whereby welding defect due to melt failure can be prevented.

### <Fourth embodiment>

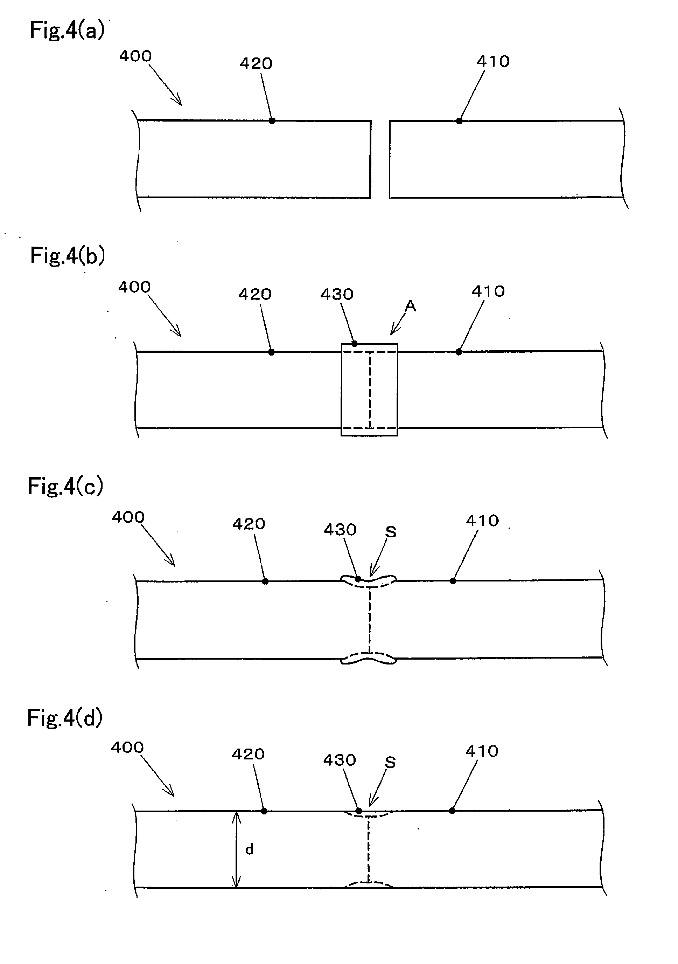

Next, the fourth embodiment of the method for manufacturing an inspection probe to which the present invention is applied is explained.
In the fourth embodiment, the first wire rod 410 and the second wire rod 420 employed are those in which the outer diameters of which are the same as the final outer diameter d of the product.
In the fourth embodiment, materials of the first wire rod 410 and the second wire rod 420 are the same as the first wire rod 110 and the second wire rod 120 of the first embodiment.
First, as shown in Fig. 4 (a) and Fig. 4(b), the first wire rod 410 and the second wire rod 420 are provided by putting together, and thereafter, the portion put together is inserted into an inner diameter side of a cylindrical member 430.
The cylindrical member 430 is so configured that an inner diameter thereof is made larger with the minute gap inevitably provided to the outer diameters of the first wire rod 410 and the second wire rod 420 and in a cylindrical shape.
The cylindrical member 430 is formed by a material having a melting point closer to a material at the side having a higher melting point than a material at the side having a lower melting point, among the materials of the first wire rod 410 and the second wire rod 420, preferably a material substantially the same as the material at the side having a higher melting point, for example, by the same material as the wire rod at the side having a higher melting point.

Next, as shown in Fig. 4(b), in the state that the portion putting the first wire rod 410 and the second wire rod 420 together is covered by the cylindrical member 430, laser beam is irradiated to the outer circumferential surfaces of the cylindrical member 430, and laser welding is performed between the cylindrical member 430 and the first wire rod 410, the cylindrical member 430 and the second wire rod 420, and the edge surface of the first wire rod 410 and the edge surface of the second wire rod 420, respectively, to make the state as shown in Fig. 4(c).
After that, as shown in Fig. 4(d), a portion of the cylindrical member 430 which is resolidified after melting and extended from the outer circumferential surfaces of the first wire rod 410 and the second wire rod 420 is subjected to centerless polishing.
In the fourth embodiment as explained above, a shrinkage cavity generating at the welded portion of the first wire rod 410 and the second wire rod 420 is buried by the cylindrical member 430, so that even when a wire rod having an outer diameter which is the same as the final outer diameter of the product is used as the first wire rod 410 and the second wire rod 420, a product having a desired outer diameter of the product can be obtained, without subjecting to a post-treatment such as padding, etc., to the shrinkage cavity.
Also, when the cylindrical member 430 is melted, a material having a lower melting point among the first wire rod 410 and the second wire rod 420 is also instantaneously melted, so that the quality of the welded portion can be well ensured.

### <Fifth embodiment>

Next, the fifth embodiment of the method for manufacturing an inspection probe to which the present invention is applied is explained.
In the fifth embodiment, as the first wire rod and the second wire rod not shown in the drawing, for example, a wire rod of iridium or a beryllium copper alloy having an outer diameter substantially the same outer diameter of the product is used.
After performing laser welding in the same manner as in the above-mentioned first embodiment, a nickel plating is applied to the outer circumferential surfaces of the first wire rod and the second wire rod including the welded portion to form a coating. At this time, a thickness of the coating is so formed that it is thicker than the depth of the shrinkage cavity generated by the welding.
Thereafter, the outer circumferential surfaces of the first wire rod and the second wire rod including the welded portion are polished until the shrinkage cavity disappears by centerless polishing to finish it to the outer diameter of the product.
According to the fifth embodiment as explained above, strength of the surface of the bonding portion is improved by the nickel plating, and the shrinkage cavity generated by the welding is buried to complete a uniform outer diameter of the product.
Incidentally, at the surface of the inspection probe after polishing, it is also possible to apply a nickel plating again, and by using the nickel plating as an undercoat, gold, rhodium, platinum, etc., may be plated thereon.
Formation of these metal coatings may be carried out by using other thin-film forming techniques such as, for example, vapor deposition and sputtering.

### <Sixth embodiment>

The inspection probe 500 of the sixth embodiment is so configured that, for example, the first wire rod 510 comprising iridium (melting point 2443°C) is made a tip to which an inspection contact portion is to be formed, and to the edge portion is bonded, for example, the second wire rod 520 comprising tungsten (melting point 3380°C) as the body portion.
The inspection probe 500 can be utilized as, for example, a probe pin of a probe card, and various probe pins of wire probe and zebra probe.
When the inspection probe 500 is a probe for a cantilever system probe card having a total length of, for example, 60 to 150 mm, it can constitute, for example, 6 to 10 mm as a tip. In this case, it can be so constituted that the bonded portion of the first wire rod 510 and the second wire rod 520 are buried at the inside of a resin for fixing the probe of the cantilever system probe card.

Such a combination of the materials, use, shape and dimensions are one of examples, and they can be optionally changed.
For example, in the case of a vertical probe in which the center portion is curved to S character shape, or bent to L character shape to have an elastic recovery power, it can be configured that an iridium wire rod having, for example, 0.5 to 2 mm or so is bonded as a tip to the bottom portion or the upper and bottom portions of a body portion comprising a copper alloy wire rod, and a rust preventing plating such as gold, nickel, etc., is applied on outer circumferential surfaces of the copper alloy wire rod.

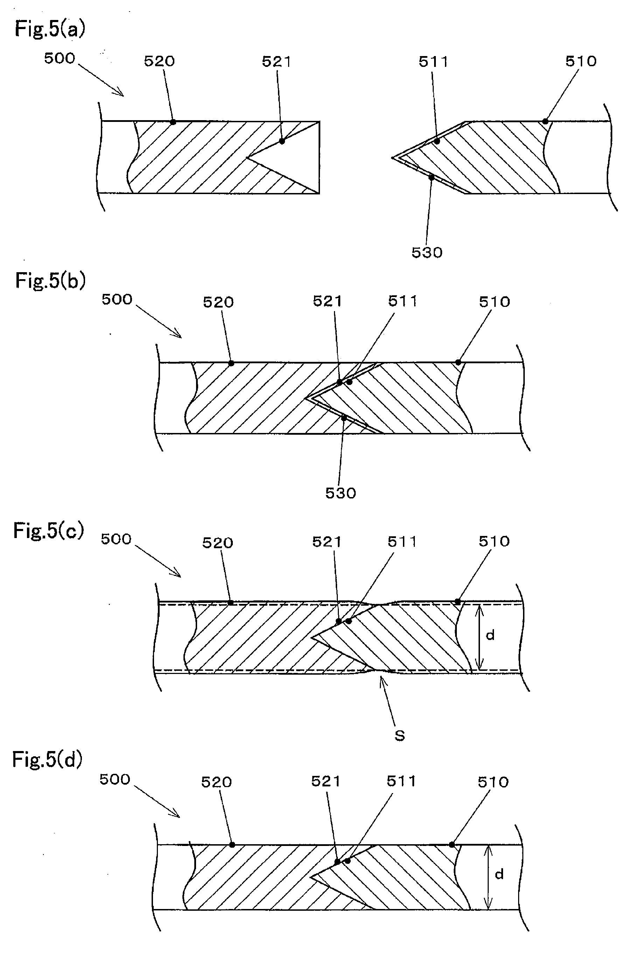

As shown in Fig. 5(a), etc. , at the bonded portion of the first wire rod 510 to the second wire rod 520, for example, a convex portion 511 tip processed to a taper shape by machining such as polishing, etc., is formed.
On the other hand, at the bonded portion of the second wire rod 520 to the first wire rod 510, a concave portion 521 with a taper hole shape and having substantially the same taper angle (side surface angle) as the convex portion 511 of the first wire rod 510 is formed. The concave portion 521 is formed by, for example, laser processing or electric discharge machining.

At the surface of the convex portion 511 of the first wire rod 510, a metal coating 530 is formed.
As a material of the metal coating 530, that having a melting point of which is closer to the melting point of tungsten than the melting point of iridium is preferred, and particularly, that having substantially the same melting point as the melting point of tungsten is preferred.
In the sixth embodiment, the metal coating 530 is formed by tungsten as one of examples.
Such a metal coating 530 made of tungsten can be formed by, for example, sputtering, vapor deposition, plating, etc.

The first wire rod 510 and the second wire rod 520 are put together, as shown in Fig. 5(b), with the state that the metal coating 530 is contacted to the second wire rod 520, so as to engage the convex portion 511 with the concave portion 521.
Thereafter, the first wire rod 510 and the second wire rod 520 are fixed to a tool, and laser beam is irradiated to the outer circumferential surfaces at the neighbor of the bonding portion under an inert gas atmosphere such as argon, etc., to melt the metal coating 530 and the second wire rod 520 to perform laser welding.
At this time, the laser beam is, for example, subjected to spot irradiation with a pulse state while rotating the first wire rod 510 and the second wire rod 520 at around the central axis sequentially, whereby the welding portions are melted instantaneously.
Suitable strength of the laser beam depends on a material or a rod diameter, so that these are optionally set.

When the welding is performed, as shown in Fig. 5(c), at the outer circumferential surfaces at the neighbor of the bonded portion of the first wire rod 510 and the second wire rod 520, there is a case where the so-called shrinkage cavity S is generated, in which the outer diameter is partially thinner than the other portions.
Thus, in the sixth embodiment, as the materials of the first wire rod 510 and the second wire rod 520, those having larger outer diameters than the final outer diameter d of the product of the inspection probe 500 are used, and after welding, the outer circumferential surfaces including the welded portion is polished, for example, by centerless polishing, to the outer diameter d of the product as shown in Fig. 5(d).
Thereafter, a necessary processing such as a tip processing is applied to the tip (a contact portion contacted to the object to be measured and provided at the opposite side to the bonding portion) of the first wire rod 510 not shown in the drawing, and further, if necessary, bending is applied to the second wire rod 520 to complete the inspection probe 500.

When a metal coating is formed by, for example, nickel plating, etc., to the outer circumferential surfaces including the welded portion of the inspection probe 500 after polishing, strength at the bonded portion can be improved thereby. Also, by using the metal coating such as nickel plating, etc., as an undercoating, a metal coating such as gold, rhodium and platinum can be formed thereon by plating.
When a gold plating is applied, electric characteristics at normal temperature can be improved.
When a platinum plating is applied, corrosion resistance at high temperatures can be improved.
When a rhodium plating is applied, corrosion resistance and wearing property at high temperatures can be improved.
After applying the plating to the whole inspection probe 500, the tip comprising iridium, etc., is polished to a needle shape, the plated coating is removed from the tip at this time, so that no effect is exerted to the performance of the tip.

According to the sixth embodiment as explained above, the following effects can be obtained.
(1) Even when the materials are difficult to welding since the melting points are markedly different from each other like iridium and tungsten, by forming a metal coating 530 comprising tungsten previously at the bonded surface of the first wire rod 510, and welding the metal coating 530 and the second wire rod 520, the difference between the melting points of the objects to be welded can be made small, whereby the first wire rod 510 and the second wire rod 520 can be bonded.
(2) By forming the convex portion 511 and the concave portion 521 at the bonding surface of the first wire rod 510 and the second wire rod 520, an area of the interface between the wire rod 510 and the metal coating 530 can be enlarged, and simultaneously, a bonding surface area of the metal coating 530 and the second wire rod 520 can be enlarged, whereby the bonding strength can be improved.
(3) The convex portion 511 and the concave portion 521 act as guides for arranging the first wire rod 510 and the second wire rod 520 to be concentric, whereby precision of the bonding portion can be ensured.
(4) Even when iridium which is excellent in corrosion resistance and wear resistance but hard and brittle is used as the tip of the inspection probe 500, by using tungsten excellent in elasticity, toughness and electrical conductivity for the body portion, performance of the inspection probe 500 as a whole can be heightened.
(5) When materials of the first wire rod 510 and the second wire rod 520 having outer diameters larger than the outer diameter d of the product are used, and a shrinkage cavity is generated at the welding by subjecting the whole portion including the welded portion to centerless polishing after the welding, the inspection probe 500 with a uniform outer diameter of a product can be obtained without subjecting to padding, etc.
(6) By applying a nickel plating to the outer circumferential surfaces including the welded portion, strength at the bonded portion can be improved.
(7) By using the nickel plating as a undercoating, either one of gold, rhodium and platinum is plated thereon, electric characteristics, corrosion resistance and wear resistance can be improved.

### <Seventh embodiment>

Next, the seventh embodiment of the method for manufacturing an inspection probe to which the present invention is applied is explained.
Incidentally, the substantially common parts with the above-mentioned sixth embodiment are applied the same reference numerals and explanation is omitted, and different point is mainly explained.
In the inspection probe 500A of the seventh embodiment, as materials of the first wire rod 510 and the second wire rod 520, those having substantially the same outer diameters as the final outer diameter of the product are used.
The first wire rod 510 and the second wire rod 520 are welded in the same manner as shown in Fig. 5(a) to Fig. 5(c) in the first embodiment.

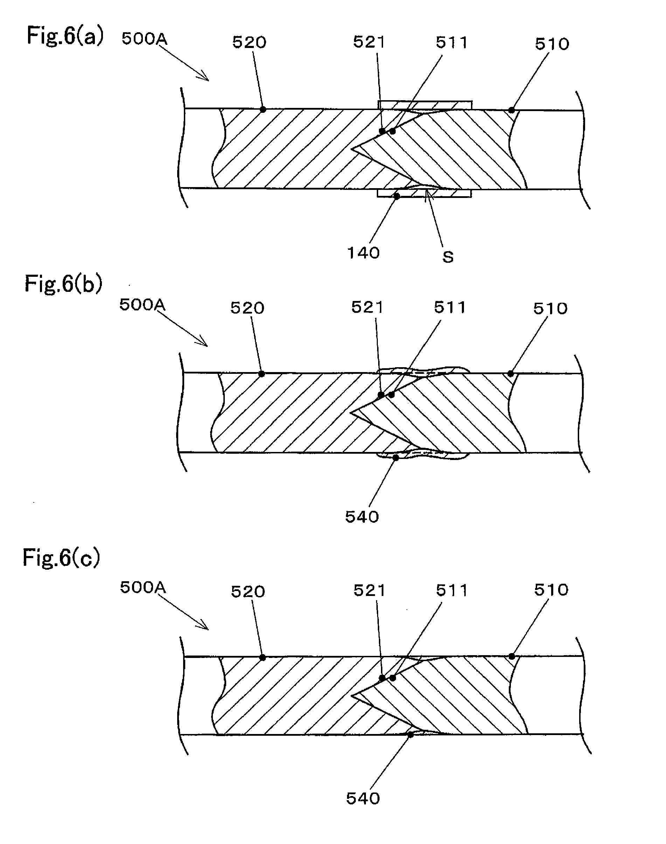

Thereafter, the welded portion of the first wire rod 510 and the second wire rod 520 is, as shown in Fig. 6(a), inserted into an inner diameter side of a cylindrical member 540 with a cylindrical shape formed by, for example, tungsten.
The cylindrical member 540 has an inner diameter which is made larger with the gap inevitably provided to the outer diameters of the first wire rod 510 and the second wire rod 520.
The length of the cylindrical member 540 to the axis direction is so set that it can cover the portion of the shrinkage cavity S formed at the welded portion.

Next, laser is irradiated to the outer circumferential surfaces of the cylindrical member 540 to heat the material, and as shown in Fig. 6(b), the cylindrical member 540 is melted to fill the shrinkage cavity portion at the welded portion. At this time, the melted cylindrical member 540 is welded with the first wire rod 510 and the second wire rod 520, respectively.
Thereafter, for example, as shown in Fig. 6(c), the portion of the melted cylindrical member 540 extended outside than the outer diameter of the product is ground off by centerless polishing, and depending on necessity, the same surface treatment, tip processing of the tip, etc., as in the sixth embodiment is/are performed to complete the inspection probe 500A.
According to the seventh embodiment as explained above, in addition to the same effects as the effects mentioned in the above sixth embodiment, a shrinkage cavity generated at the welding can be easily filled and an inspection probe with a uniform outer diameter of the product can be obtained. It is also possible to use a material having substantially the same outer diameter with the outer diameter of the product as materials of the first wire rod 510 and the second wire rod 520, whereby yield of the material can be improved.

### (Modified example)

The present invention is not limited to the embodiments explained above, and various modifications or changes can be conducted, which are also included in the technical range of the present invention.
(1) In the first and the fourth embodiments, the first wire rod is formed by iridium and the second wire rod is formed by a rhenium-tungsten alloy, and in the second, the third and the fifth embodiments, the second wire rod is formed by a beryllium-copper alloy, but the present invention is not limited thereto, and the invention can be applied to the production of an inspection probe in which wire rods comprising the other materials are to be bonded.
   For example, the tip of the inspection probe may be formed by, in addition to pure iridium, an iridium alloy containing iridium, for example, a platinum-iridium alloy, a palladium-iridium, etc., or a different kind of metals such as osmium, etc. Also, other platinum alloys, palladium alloys, etc., may be used.
   The body portion may be formed by, in addition to the rhenium-tungsten-based alloy or the beryllium-copper alloy, pure tungsten, other tungsten-based alloys, silver-palladium-copper alloys, aluminum-based alloys, other copper alloys, palladium alloys, gold alloys, silver alloys or other kind of metals.
(2) When the convex portion and the concave portion are to be provided at the edge surfaces of each wire rod, these shapes are not limited to the taper shape as described in the respective embodiments, and may be other shapes. Its preparation method is also not particularly limited. In addition, in the respective embodiments, a convex portion is formed at the side of the wire rod to which the tip is to be provided, but the convex portion may be formed conversely at the other (body side) wire rod. In this case, in the viewpoint of ensuring the welding quality, it is preferred that the concave portion is provided to the wire rod of the higher melting point side, since the wire rod of the lower melting point side is not excessively melted or melt failure of the wire rod of the higher melting point side is difficultly generated.
(3) In the respective embodiments, the outer circumferential surfaces of the welded portion are subjected to centerless polishing, and the means of the polishing is not particularly limited.
(4) In the respective embodiments, the metal coating such as nickel, etc., is formed on the surface of the inspection probe by plating, and the means to form such a metal coating is not limited to the plating, and other thin-film forming techniques such as vapor deposition or sputtering may be used.
(5) In the sixth and the seventh embodiments, the metal coating is formed by tungsten, but it is not limited to this, and the material of the metal coating can be optionally changed. For example, the metal coating may be formed by a rhenium-tungsten alloy having an intermediate melting point between the melting points of iridium and tungsten.
   When the combination of the first wire rod and the second wire rod is different from iridium-tungsten in the respective embodiments, the material of the metal coating can be determined in consideration with the melting points of the materials of the respective wire rods.
   In the respective embodiments, a metal coating comprising a material having a higher melting point than the melting point of the wire rod is formed to the bonding surface of the wire rod of the lower melting point side. In place of this, a metal coating comprising a material having a lower melting point than the melting point of the wire rod may be formed to the bonding surface of the wire rod of the higher melting point side, whereby making the difference in the melting point of the wire rod of the lower melting point side small to improve the welding quality. In this case, the melting point of the material of the metal coating is preferably one closer to the melting point of the material of the wire rod of the lower melting point side than the melting point of the material of the wire rod of the higher melting point side, in particular, it is more preferred to use a material having substantially the same melting point as that of the wire rod.
(6) In the sixth and the seventh embodiments, a convex portion and a concave portion are formed to the first and the second wire rods, respectively, then, the metal coating is formed and the rods are welded, but this is not limited thereto, and the metal coating may be formed to one of them in the state that the edge surface of each wire rod is plane, and then, welded. For example, a metal coating having a lower melting point to a wire rod is formed to the edge surface of the wire rod of the higher melting point side by plating, and then, welded.
(7) In the respective embodiments, whole inspection probe including the welded portion is polished lower than the outer diameter of the shrinkage cavity portion, but this is not limited thereto, and a part including the welded portion alone may be polished. For example, in the range of, for example, 1 to 2 mm to the lengthwise direction including the welded portion, it may be polished so that it sunk, for example, 0.2 micron or so to the other portions. In this case, an outer diameter of the product at the neighbor of the welded portion alone becomes smaller than the other portions, and a groove to the circumferential direction is formed. It has been known that there is no problem in strength for practical use so long as the diameter is not made extremely thin as compared with the other portions. According to this method, as compared with the case where the whole product is to be polished, a number of steps of polishing can be reduced, and productivity can be improved.

### EXPLANATION OF REFERENCE NUMERALS

| | | | |
|---|---|---|---|
| 100 | Inspection probe (First embodiment) | | |
| 110 | First wire rod | 120 | Second wire rod |
| A | Region to be welded | S | Sink mark portion |
| d | Outer diameter of product | | |
| 200 | Inspection probe (Second embodiment) | | |
| 210 | First wire rod | 211 | Concave portion |
| 220 | Second wire rod | 221 | Convex portion |
| 300 | Inspection probe (Third embodiment) | | |
| 310 | First wire rod | 310a | Hole portion |
| 311 | Concave portion | | |
| 320 | Second wire rod | 321 | Convex portion |
| 400 | Inspection probe (Fourth embodiment) | | |
| 410 | First wire rod | 420 | Second wire rod |
| 430 | Cylindrical member | | |
| 500 | Inspection probe (Sixth embodiment) | | |
| 500A | Inspection probe (Seventh embodiment) | | |
| 510 | First wire rod | 511 | Convex portion |
| 520 | Second wire rod | 521 | Concave portion |
| 530 | Metal coating | 540 | Cylindrical member |

## Claims

1. A method for manufacturing an inspection probe which is configured by bonding a first wire rod and a second wire rod, at least one of which has an inspection contact portion at a tip thereof, which comprises
performing laser welding the first wire rod and the second wire rod in a state of putting together by irradiating laser beam to outer circumferential surfaces at a bonded portion, and an energy quantity applied to a material of a higher melting point side among the first wire rod and the second wire rod by the laser beam is made larger than an energy quantity applied to a material of a lower melting point side.

2. The method for manufacturing an inspection probe according to Claim 1, wherein after the laser welding is performed, outer circumferential surfaces at a welded portion are polished to an outer diameter of a product.

3. A method for manufacturing an inspection probe which is configured by bonding a first wire rod and a second wire rod, at least one of which has an inspection contact portion at a tip thereof, which comprises
laser welding the first wire rod and the second wire rod in a state of putting together by irradiating laser beam to outer circumferential surfaces at a bonded portion, and
after the laser welding is performed, outer circumferential surfaces at a welded portion are polished to an outer diameter of a product.

4. The method for manufacturing an inspection probe according to any one of Claim 1 to Claim 3, wherein a convex portion is formed at one of edge surfaces of the first wire rod and the second wire rod, and a concave portion which is engaged with the convex portion and to guide the first wire rod and the second wire rod to be substantially concentric is formed at the edge surface of the other.

5. A method for manufacturing an inspection probe which is configured by bonding a first wire rod and a second wire rod which are formed by materials having different melting points, at least one of which has an inspection contact portion at a tip thereof, which comprises
forming a metal coating comprising a material having a higher melting point than a melting point of a material of the wire rods at a bonding surface of a side having a lower melting point among materials of the first wire rod and the second wire rod, and
putting the first wire rod and the second wire rod together, and welding these by heating.

6. The method for manufacturing an inspection probe according to Claim 5, wherein a convex portion is formed at one of a bonding surface of the first wire rod and a bonding surface of the second wire rod, and a concave portion which is engaged with the convex portion is formed at a bonding surface of the other, and
the first wire rod and the second wire rod are putting together so that the convex portion and the concave portion are engaged with, and are welded by heating.

7. The method for manufacturing an inspection probe according to Claim 5 or Claim 6, wherein the metal coating is formed by sputtering, plating or vapor deposition using a material having a melting point closer to a higher melting point among the material of the first wire rod and the material of the second wire rod than a lower one.

8. A method for manufacturing an inspection probe which is configured by bonding a first wire rod and a second wire rod which are formed by materials having different melting points, at least one of which has an inspection contact portion at a tip thereof, which comprises
forming a metal coating comprising a material having a lower melting point than a melting point of a material of the wire rods at a bonding surface of a side having a higher melting point among materials of the first wire rod and the second wire rod, and
putting the first wire rod and the second wire rod together, and welding these by heating.

9. The method for manufacturing an inspection probe according to Claim 8, wherein a convex portion is formed at one of a bonding surface of the first wire rod and a bonding surface of the second wire rod, and a concave portion which is engaged with the convex portion is formed at the other, and
the first wire rod and the second wire rod are putting together so that the convex portion and the concave portion are engaged with, and are welded by heating.

10. The method for manufacturing an inspection probe according to Claim 8 or Claim 9, wherein the metal coating is formed by sputtering, plating or vapor deposition using a material having a melting point closer to a lower melting point among the material of the first wire rod and the material of the second wire rod than a higher one.

11. The method for manufacturing an inspection probe according to any one of Claim 1 to Claim 10, wherein at least one of the first wire rod and the second wire rod is formed by either one of tungsten, a tungsten alloy, a copper alloy, a silver alloy, a palladium alloy or a gold alloy, and the other is formed by iridium or an iridium alloy.

12. The method for manufacturing an inspection probe according to any one of Claim 1 to Claim 11, wherein at least one of the first wire rod and the second wire rod has an outer diameter larger than an outer diameter of a product, and
outer circumferential surfaces including the bonded portion are polished to the outer diameter of a product after welding the first wire rod and the second wire rod.

13. The method for manufacturing an inspection probe according to any one of Claim 1 to Claim 11, wherein the first wire rod and the second wire rod are welded, and then, a ring member made of a metal is provided at a periphery of the bonded portion and melted to fill a wall reduced portion caused by welding.

14. The method for manufacturing an inspection probe according to any one of Claim 1 to Claim 11, wherein
an outer diameter of the first wire rod is formed larger than that of the second wire rod and the first wire rod has a hole portion at an edge surface into which the second wire rod is to be inserted, and
after performing laser welding of the first wire rod and the second wire rod in a state that the second wire rod is inserted into the hole portion of the first wire rod, outer circumferential surfaces of the first wire rod are polished to an outer diameter of a product.

15. A method for manufacturing an inspection probe which is configured by bonding a first wire rod and a second wire rod, at least one of which has an inspection contact portion at a tip thereof, which comprises
in a state that an edge surface of the first wire rod and an edge surface of the second wire rod are putting together, arranging the portion at which the rods are putting together at an inner diameter side of a cylindrical member,
irradiating laser beam to the cylindrical member to perform laser welding the cylindrical member to the first wire rod and the second wire rod, respectively, and polishing outer circumferential surfaces of the welded portion to an outer diameter of a product.

16. The method for manufacturing an inspection probe according to Claim 15, wherein the first wire rod and the second wire rod are constituted by materials having different melting points, and
a material of the cylindrical member has a melting point closer to a higher melting point among the material of the first wire rod and the material of the second wire rod than a lower one.

17. The method for manufacturing an inspection probe according to any one of Claim 1 to Claim 16, wherein after the laser welding is performed, a metal coating is formed at outer circumferential surfaces of a welded portion, and then, polishing thereof is carried out.

18. The method for manufacturing an inspection probe according to any one of Claim 1 to Claim 17, wherein after polishing outer circumferential surfaces at a welded portion, a metal coating is formed thereon.

19. The method for manufacturing an inspection probe according to Claim 17 or Claim 18, wherein the metal coating is a nickel coating.

20. The method for manufacturing an inspection probe according to Claim 19, wherein a coating comprising at least one of gold, rhodium and platinum is formed on the surface of the nickel coating.
